# EUROPEAN PATENT APPLICATION

(11) **EP 4 554 361 A1**
(43) Date of publication of application: **14.05.2025**
(21) Application number: 24209892.9
(22) Date of filing: 30.10.2024
(51) Int. Cl.: H10K 59/131, H05K 1/18, H10K 50/88

(54) **DISPLAY DEVICE AND METHOD OF MANUFACTURING DISPLAY DEVICE**

(30) Priority: 10.11.2023 KR 20230155268
(71) Applicant: Samsung Display Co., Ltd., Gyeonggi-do 17113 (KR)
(72) Inventor: KIM, Taeoh, 17113 Yongin-si (KR); PARK, Hanho, 17113 Yongin-si (KR); KANG, Eui Jeong, 17113 Yongin-si (KR); KOO, Minsang, 17113 Yongin-si (KR); KIM, Sujeong, 17113 Yongin-si (KR); PARK, Jeongjin, 17113 Yongin-si (KR); SONG, Si Joon, 17113 Yongin-si (KR)
(74) Representative: Walaski, Jan Filip

(57) **Abstract**

A display device includes a display panel, a circuit board coupled to the display panel, and a metal pattern. The display panel includes a base layer including a pad electrode exposed through an opening, and a circuit layer disposed on the base layer and including at least one signal line electrically connected to the pad electrode. The circuit board includes a base film including a first part having a first thickness and a second part having a second thickness that is greater than the first thickness, and a bump electrode disposed on the first part. The first part is disposed between the pad electrode and the bump electrode, and the metal pattern is disposed on the pad electrode and the bump electrode and electrically connects the pad electrode and the bump electrode to each other.

## Description

### TECHNICAL FIELD

The present disclosure relates to a display device, and more particularly, to a display device including a base film capable of rear bonding to a circuit board, and a method of manufacturing the display device.

### DISCUSSION OF THE RELATED ART

Electronic devices such as smart phones, tablet computers, laptop computers, vehicle navigation systems, and smart televisions have been developed. These electronic devices are provided with display devices to display visual information to users.

Various types of display devices have been developed to satisfy desired user experience (UX)/user interface (UI) designs. Display devices have been developed to provide a wide display area and a narrow non-display area so that the display devices may provide an increased screen size while reducing the overall size of the device, particularly, a bezel which may surround the displayed image.

### SUMMARY

A display device includes a display panel that displays an image, a circuit board coupled to the display panel, and a metal pattern that electrically connects the display panel and the circuit board to one another. The display panel includes a base layer including a pad electrode exposed through an opening and a circuit layer disposed on the base layer and including at least one signal line electrically connected to the pad electrode. The circuit board includes a base film including a first part having a first thickness and a second part having a second thickness that is greater than the first thickness and a bump electrode disposed on the first part. The first part is disposed between the pad electrode and the bump electrode, and the metal pattern is disposed on the pad electrode and the bump electrode and electrically connects the pad electrode and the bump electrode to each other.

The pad electrode may be a first pad among a plurality of pad electrodes, and the plurality of pad electrodes may extend in a first direction and may be arranged in a second direction intersecting the first direction.

A plurality of bump electrodes and a plurality of metal patterns may correspond to the plurality of pad electrodes.

The display device may further include an adhesive layer disposed between the first part and the pad electrode.

A thickness of the adhesive layer may be greater than the first thickness.

The adhesive layer may include a non-conductive film.

The second part includes a first sub-portion parallel to the base layer, and a second sub-portion extending from the first sub-portion and including an inclined surface.

The second sub-portion may be disposed between the first sub-portion and the first part and may integrally connect the first sub-portion and the first part.

The second part may include an inclined portion of which a thickness gradually decreases toward the first part.

The inclined portion may be adjacent to the first part.

The first part may extend in parallel to the pad electrode.

An edge of the first part and an edge of the bump electrode may be aligned in parallel to each other.

The base layer may include a first sub-base layer in which the opening is defined, and a second sub-base layer disposed on the first sub-base layer. The pad electrode may be disposed between the first sub-base layer and the second sub-base layer.

The signal line may be disposed on an upper surface of the second sub-base layer, and a contact hole may be formed in the second sub-base layer, and the signal line and the pad electrode may be connected through the contact hole.

The first thickness may be within a range of about 3% to about 20% of the second thickness.

The display panel may include a display area and a non-display area, and the pad electrode may overlap the non-display area.

A method of manufacturing a display device includes forming a display panel including a base layer including a pad electrode exposed through an opening and a circuit layer including at least one signal line electrically connected to the pad electrode. A circuit board is formed including a base film including a first part having a first thickness and a second part having a second thickness that is greater than the first thickness, and a plurality of bump electrodes disposed on the first part, aligning the display panel and the circuit board such that the first part faces the pad electrodes. The base film is bent such that the first part is parallel to the pad electrodes. A plurality of metal patterns is formed on the bump electrodes and the pad electrodes to electrically connect the bump electrodes and the pad electrodes to each other through the metal patterns.

The forming of the circuit board may include providing a preliminary base film and preliminary bump electrodes on an upper surface of the preliminary base film, forming a depression extending in a first direction from a lower surface of the preliminary base film facing the upper surface, and cutting the preliminary base film and the preliminary bump electrodes in a direction parallel to the first direction while overlapping the depression.

The forming of the circuit board may further include arranging an adhesive layer on the depression before the cutting of the preliminary base film and the preliminary bump electrodes.

An edge of the adhesive layer, an edge of the first part, and an edge of the bump electrodes may be aligned in parallel to in a thickness direction of the base film.

The forming of the circuit board may further include inverting the preliminary base film and the preliminary bump electrodes before the forming of the depression.

The bending of the base film may include bending the base film by directly pressing the bump electrode disposed on the first part toward the pad electrode.

An angle formed between the first part and the second part may be an obtuse angle before the bending of the base film.

The forming of the metal patterns may include arranging a metal layer on the pad electrodes and the bump electrodes, and patterning the metal layer to form the metal pattern.

The patterning of the metal layer may include exposing a portion of the metal layer, in an area that does not overlap the pad electrodes, with a laser beam.

### BRIEF DESCRIPTION OF THE FIGURES

The above and other objects and features of the present disclosure will become apparent by describing in detail embodiments thereof with reference to the accompanying drawings.
FIG. 1 is a perspective view of an electronic device.
FIG. 2 is an exploded perspective view of the electronic device.
FIG. 3 is a cross-sectional view of a display device along line I-I' of FIG. 2.
FIG. 4 is a schematic cross-sectional view of a display module.
FIG. 5 is a plan view of a display panel.
FIG. 6 is a cross-sectional view of the display module.
FIG. 7 is a plan view of a display panel.
FIG. 8 is an enlarged plan view illustrating a portion of the display device.
FIG. 9 is a cross-sectional view of the display device along line II-II' of FIG. 8.
FIG. 10A is a cross-sectional view of a flexible circuit board.
FIG. 10B is a cross-sectional view of the flexible circuit board.
FIG. 11 is a flowchart illustrating a method of manufacturing a display device.
FIGS. 12A-12F, 13A-13C, and 14A-14B are views illustrating some operations of a method of manufacturing a display device.

### DETAILED DESCRIPTION

In describing embodiments of the present disclosure illustrated in the drawings, specific terminology is employed for sake of clarity. However, the present disclosure is not necessarily intended to be limited to the specific terminology so selected, and it is to be understood that each specific element includes all technical equivalents which operate in a similar manner.

In the present specification, the expression that a first component (or an area, a layer, a part, a portion, etc.) is "disposed on", "connected with" or "coupled to" a second component may mean that the first component is directly disposed on/connected with/coupled to the second component or may mean that a third component is interposed therebetween.

The same reference numerals may refer to the same components throughout the specification and the drawings. Further, in the drawings, the thickness, the ratio, and the dimension of components may be exaggerated for effective description of technical contents.

The term "and/or" includes all combinations of one or more components that may be defined by associated configurations.

The terms "first", "second", etc. are used to describe various components, but the components should not necessarily be limited by the terms. The terms are used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

Further, the terms "under", "beneath", "on", "above", etc. are used to describe a relationship between components illustrated in the drawings. The terms have relative concepts and are described with reference to a direction indicated in the drawing.

It will be understood that the terms "include", "comprise", "have", etc. specify the presence of features, numbers, steps, operations, elements, or components, described in the specification, or a combination thereof, not precluding the presence or additional possibility of one or more other features, numbers, steps, operations, elements, or components or a combination thereof.

Hereinafter, embodiments will be described with reference to the accompanying drawings.

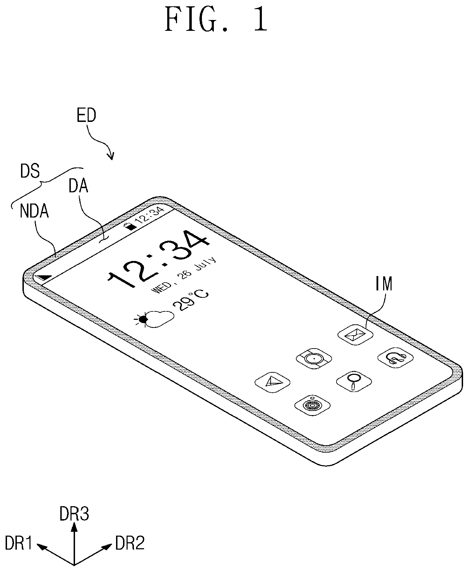

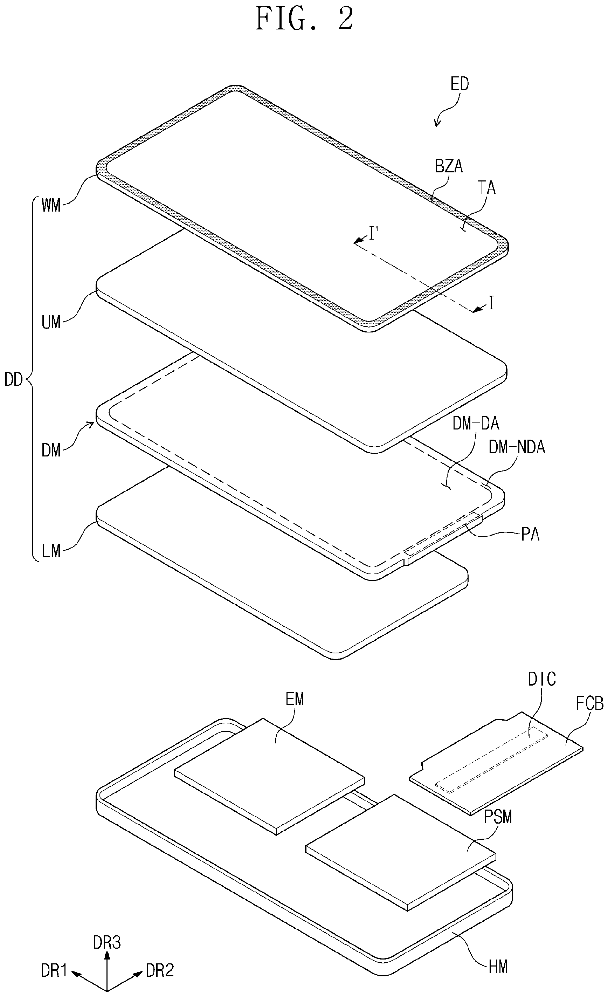

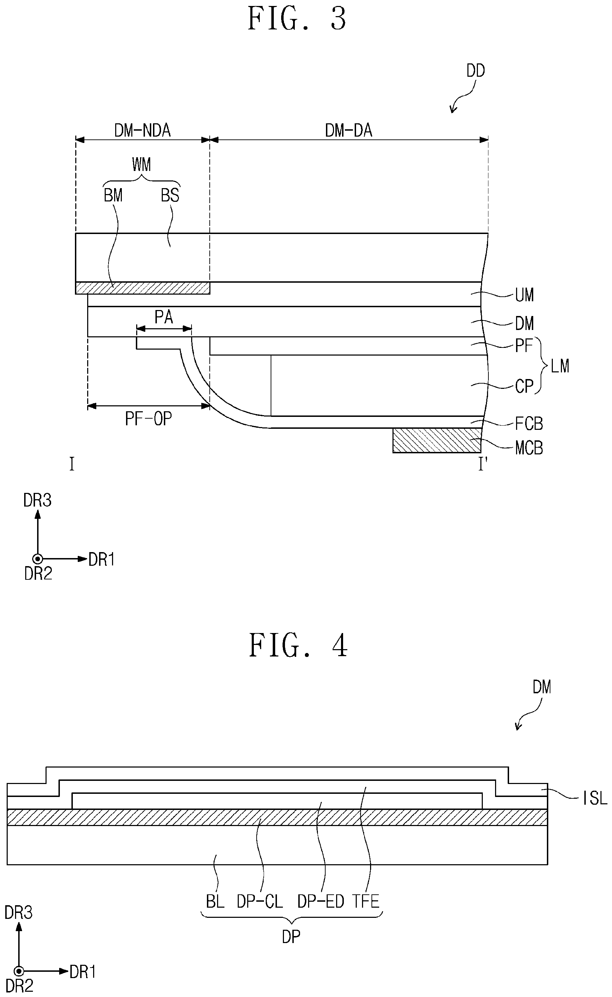

FIG. 1 is a perspective view of an electronic device. FIG. 2 is an exploded perspective view of the electronic device. FIG. 3 is a cross-sectional view of a display device along line I-I' of FIG. 2.

Referring to FIG. 1, an electronic device ED may include a display surface DS defined by a first direction DR1 and a second direction DR2 intersecting the first direction DR1. The electronic device ED may provide an image IM to a user through the display surface DS.

The display surface DS may include a display area DA and a non-display area NDA at least partially surrounding the display area DA (as used herein, the phrase "at least partially surrounding" may mean touching on one or more sides, up to and including fully surrounding on all sides). The display area DA is an area that displays the image IM, and the non-display area NDA is an area that does not display the image IM. The non-display area NDA may fully surround the display area DA. However, the arrangement is not necessarily limited thereto, and the shape of the display area DA and the shape of the non-display area NDA may be modified.

Hereinafter, a direction substantially perpendicular to a plane defined by the first direction DR1 and the second direction DR2 is defined as a third direction DR3. The third direction DR3 serves as a standard for distinguishing a front surface and a rear surface of each of structures. In the present specification, the wording "on a plane" or "in a plan view" is defined as a state in which a display device DD is viewed in the third direction DR3.

The electronic device ED may be a foldable electronic device that may be folded about a folding axis without cracking or otherwise sustaining damage. The folding axis may be parallel to the first direction DR1 or the second direction DR2, and a folding area may be defined in a portion of the display area DA. The electronic device ED may be in-folded such that the display areas DA face each other (thereby creating a state in which the display is protected while folded) or out-folded such that the display areas DA are folded away from each other (thereby creating a state in which the display may still be viewed while folded).

As illustrated in FIG. 2, the electronic device ED may include the display device DD, an electronic module EM, a power supply module PSM, and a housing HM. FIG. 2 briefly illustrates the electronic device ED, and the electronic device ED may further include a mechanical structure (e.g., a hinge) for controlling an operation (e.g., folding or rolling) of the display device DD.

The display device DD generates the image IM and senses an external input. The display device DD includes a window WM, an upper structure UM, a display module DM, a lower structure LM, a flexible circuit board (or a circuit board) FCB, and a driving chip DIC. The upper structure UM includes structures arranged on the display module DM, and the lower structure LM includes structures arranged under the display module DM. As used herein, the phrase "structure" represents a layer or element.

The window WM provides a front surface of the electronic device ED. The window WM includes a transmissive area TA and a bezel area BZA. The display area DA and the non-display area NDA of the display surface DS illustrated in FIG. 1 are defined by the transmissive area TA and the bezel area BZA. The transmissive area TA is an area through which an image passes, and the bezel area BZA is an area that covers a structure disposed under the window WM.

The display module DM includes a display area DM-DA and a non-display area DM-NDA corresponding to the display area DA and the non-display area NDA illustrated in FIG. 1. In the specification, an expression "an area/part and an area/part correspond to each other" means that the area/part and the area/part overlap each other and is not necessarily limited to the same area.

A pad area PA is disposed on one side of the non-display area DM-NDA. The pad area PA is an area that is electrically bonded (or connected) to the flexible circuit board FCB, which will be described below. The pad area PA may be defined on a rear surface of the display module DM.

The display module DM has a substantially quadrilateral shape. Here, the "substantially quadrilateral shape" includes not only a quadrilateral shape in the mathematical sense but also a shape similar to the quadrilateral shape, which may be recognized as a quadrilateral shape by a user. For example, a substantially quadrilateral shape may include a quadrilateral shape having rounded corner areas. Further, in the substantially quadrilateral shape, edges of a display module DM are not necessarily limited to a straight shape, and the edges may include curved areas.

The upper structure UM may include a protective film or optical film. The optical film may include a polarizer and a retarder to reduce reflection of external light. The lower structure LM may include a protective film that protects the display module DM, a support structure that supports the display module DM, a digitizer, and the like. The upper structure UM and the lower structure LM will be described below in detail.

The flexible circuit board FCB is disposed under the display module DM. The flexible circuit board FCB may be bonded to a rear surface of the display module DM. The flexible circuit board FCB electrically connects the display module DM and a main circuit board MCB (see FIG. 3) to one another. The flexible circuit board FCB includes at least one insulating layer and at least one conductive layer. The conductive layer may include a plurality of signal lines.

The driving chip DIC may be mounted on the flexible circuit board FCB. The driving chip DIC may include a driving circuit, for example, data driving circuits, for driving pixels of the display module DM. A structure in which the driving chip DIC is mounted on the flexible circuit board FCB is illustrated in FIG. 2, but it is not necessarily limited thereto. For example, the driving chip DIC may be mounted on the display module DM or a main circuit board MCB.

The electronic module EM may include a control module, a wireless communication module, an image input module, a sound input module, a sound output module, a memory, an external interface module, and the like. The electronic module EM may include the main circuit board MCB, and the modules may be mounted on the main circuit board MCB or may be electrically connected to the main circuit board MCB through the flexible circuit board. The electronic module EM is electrically connected to the power supply module PSM.

The electronic device ED may further include an electro-optical module. The electro-optical module may be an electronic component that outputs or receives an optical signal. The electro-optical module may include a camera module and/or a proximity sensor. The camera module may capture an external image through a portion of the display module DM.

The housing HM illustrated in FIG. 2 is coupled to the display device DD, for example, the window WM, to accommodate the other modules. It is illustrated that the housing HM has an integral shape (e.g., a singular uninterrupted structure), but the present disclosure is not necessarily limited thereto. The housing HM may include a plurality of portions (e.g., a side edge portion and a bottom portion) coupled to each other.

Referring to FIG. 3, the window WM may include a base substrate BS and a bezel pattern BM disposed on a lower surface of the base substrate BS. The base substrate BS may include a synthetic resin film or a glass substrate. The base substrate BS may have a multi-layer structure. The base substrate BS may include a thin film glass substrate, a protective film disposed on the thin film glass substrate, and an adhesive layer that bonds the thin film glass substrate and the protective film.

The bezel pattern BM, which is a colored light shielding film, may be formed by, for example, a coating method. The bezel pattern BM may include a base material and a dye or pigment mixed with the base material. The bezel pattern BM overlaps the non-display area NDA illustrated in FIG. 1 and the bezel area BZA illustrated in FIG. 2. The bezel pattern BM may be disposed on the lower surface of the base substrate BS. When the base substrate BS has a multi-layer structure, the bezel pattern BM may be disposed between interfaces defined by a plurality of layers. For example, the bezel pattern BM may be disposed between the thin film glass substrate and the protective film. The window WM may further include a hard coating layer, a fingerprint preventing layer, and/or a reflection preventing layer on an upper surface of the base substrate BS.

The upper structure UM may include an upper film. The upper film may include a synthetic resin film. The synthetic resin film may include polyimide, polycarbonate, polyamide, triacetylcellulose, polymethylmethacrylate, or polyethylene terephthalate.

The upper film may absorb an external impact applied to a front surface of the display device DD. The display module DM may include a color filter that replaces a polarizing film as a reflection preventing structure, and accordingly, a front impact strength of the display device DD may be reduced. The upper film may compensate for the reduced impact strength by applying the color filter.

The upper structure UM overlaps the bezel area BZA (see FIG. 2) and the transmissive area TA (see FIG. 2). The upper structure UM may overlap only a portion of the bezel area BZA. The portion of the bezel pattern BM may be exposed from the upper structure UM. The upper structure UM may be omitted. The upper structure UM may be replaced with an optical film including a polarizer and a retarder.

An adhesive layer that bonds the upper structure UM and the window WM to one another may be further included between the upper structure UM and the window WM. The adhesive layer may be, for example, a pressure sensitive adhesive (PSA) film or an optically clear adhesive (OCA) structure.

The display module DM is disposed under the upper structure UM. The display module DM overlaps the bezel area BZA and the transmissive area TA. The display module DM may completely overlap the upper structure UM within the bezel area BZA. A side surface of the display module DM may be aligned with a side surface of the upper structure UM, and an edge of the display module DM may be aligned with an edge of the upper structure UM on a plane (e.g., in a plan view).

The pad area PA of the display module DM within the bezel area BZA may overlap the upper structure UM. A portion of the display module DM corresponding to the pad area PA may be bonded to a lower surface of the upper structure UM by the adhesive layer. The pad area PA overlaps the upper structure UM, and the portion of the display module DM, which overlaps the pad area PA, is coupled to the upper structure UM. Thus, when the flexible circuit board FCB is bonded to the pad area PA, the upper structure UM may sufficiently support the pad area PA.

The lower structure LM may include a lower film PF and a cover panel CP. The lower structure LM may further include a support plate and a digitizer.

The lower film PF may expose the pad area PA of the display module DM. The lower film PF may have a smaller size than that of the display module DM. For example, the lower film PF may overlap only the display area DM-DA of the display module DM. An open area PF-OP corresponding to the non-display area DM-NDA may be defined in the lower film PF. Alternatively, the lower film PF may have a size that substantially corresponds to the display module DM. In this case, the open area PF-OP corresponding to the pad area PA may be defined in the lower film PF. The pad area PA may be exposed through the open area PF-OP.

The lower film PF may expose the pad area PA. The lower film PF may have a smaller area than that of the display module DM. For example, the lower film PF may overlap only the display area DA. The lower film PF may have substantially the same area as that of the display module DM. The open area PF-OP corresponding to the pad area PA may be defined in the lower film PF. The pad area PA may be exposed through the open area PF-OP.

The cover panel CP may be disposed under the lower film PF. The cover panel CP may increase a resistance force against a compressive force generated by external pressure. Thus, the cover panel CP may prevent deformation of the display module DM. The cover panel CP may include a flexible plastic material such as polyimide or polyethylene terephthalate. Further, the cover panel CP may be a colored film having a low light transmittance. The cover panel CP may absorb ambient light. For example, the cover panel CP may be a black synthetic resin film. When the display device DD is viewed from a front side of the window WM, components arranged under the cover panel CP might not be visually recognized by the user.

The support plate may be further disposed under the cover panel CP. The support plate may include a metal having high strength. The support plate may also include a reinforced fiber composite. The support plate may include a reinforced fiber disposed inside a matrix part. The reinforced fiber may be a carbon fiber or a glass fiber. The matrix part may include a polymer resin. The matrix part may include a thermoplastic resin. For example, the matrix part may include a polyamide-based resin or a polypropylene-based resin. For example, the reinforced fiber composite may be carbon fiber reinforced plastic (CFRP) or glass fiber reinforced plastic (GFRP).

The main circuit board MCB may be placed on a lower surface of the flexible circuit board FCB. The flexible circuit board FCB may include an insulating film and conductive wiring lines mounted on the insulating film. The main circuit board MCB may include signal lines and various other electronic elements. The electronic elements may be connected to the signal lines and electrically connected to the display module DM. The electronic elements generate various electrical signals, for example, signals for generating an image or signals for detecting an external input, or process sensed signals. A distinct main circuit board MCB may correspond to each of the electrical signals for the generation and processing, and three or more main circuit boards MCB may be provided, but the present disclosure is not necessarily limited thereto.

The main circuit board MCB may include the driving chip DIC (see FIG. 2) mounted within the main circuit board MCB.

Referring to FIGS. 2 and 3, the flexible circuit board FCB is bonded (rearsurface-bonded) to the rear surface of the display module DM. Since the non-display area DM-NDA of the display module DM is not bent, defects that occur in the non-display area DM-NDA of the display module DM during the bending may be prevented. Further, an area of the bezel area BZA of the window WM for covering the non-display area DM-NDA of the display module DM may be reduced.

FIG. 4 is a schematic cross-sectional view of a display module.

Referring to FIG. 4, the display module DM may include the display panel DP and an input sensing layer ISL. The display panel DP may include a base layer BL, a circuit layer DP-CL, a display element layer DP-ED, and an encapsulation layer TFE.

The circuit layer DP-CL is disposed on an upper surface of the base layer BL. The base layer BL may be a flexible substrate that may be bent, folded, and rolled. The base layer BL may be a glass substrate, a metal substrate, a polymer substrate, or the like. However, it is not necessarily limited thereto, and the base layer BL may be an inorganic layer, an organic layer, or a composite material layer. For example, the base layer BL has the same shape as that of the display panel DP.

The base layer BL may have a multi-layer structure. For example, the base layer BL may include a first synthetic resin layer, a second synthetic resin layer, and an inorganic layer disposed therebetween. Each of the first and second synthetic resin layers may include a polyimide-based resin, but they are not necessarily particularly limited thereto.

The circuit layer DP-CL may be disposed on the base layer BL. The circuit layer DP-CL may include a plurality of insulating layers, a plurality of semiconductor patterns, a plurality of conductive patterns, and the signal lines. The circuit layer DP-CL may include a driving circuit of a pixel. Hereinafter, unless otherwise specified, when component A and component B are arranged on the same layer, it is interpreted that component A and component B are formed by the same process and thus include the same material or be part of the same laminated structure. The conductive patterns or the semiconductor patterns arranged on the same layer may be interpreted as described above.

The display element layer DP-ED may be disposed on the circuit layer DP-CL. The display element layer DP-ED may include a light emitting element. For example, the light emitting element may include an organic light emitting material, an inorganic light emitting material, an organic-inorganic light emitting material, a quantum dot, a quantum rod, a micro-light emitting diode (LED), or a nano-LED.

The encapsulation layer TFE may be disposed on the display element layer DP-ED. The encapsulation layer TFE may protect the display element layer DP-ED, i.e., the light emitting element, from foreign substances such as moisture, oxygen, and dust particles. The encapsulation layer TFE may include at least one inorganic encapsulation layer. The encapsulation layer TFE may include a laminated structure of a first inorganic encapsulation layer/an organic encapsulation layer/a second inorganic encapsulation layer.

The input sensing layer ISL may be directly disposed on the display panel DP. The input sensing layer ISL may detect an input of a user using, for example, an electromagnetic induction method or a capacitance method. The display panel DP and the input sensing layer ISL may be formed through a continuous process. Here, saying that the input sensing layer ISL is directly disposed on the display panel DP may mean that a third component is not disposed between the input sensing layer ISL and the display panel DP. For example, a separate adhesive layer might not be disposed between the input sensing layer ISL and the display panel DP.

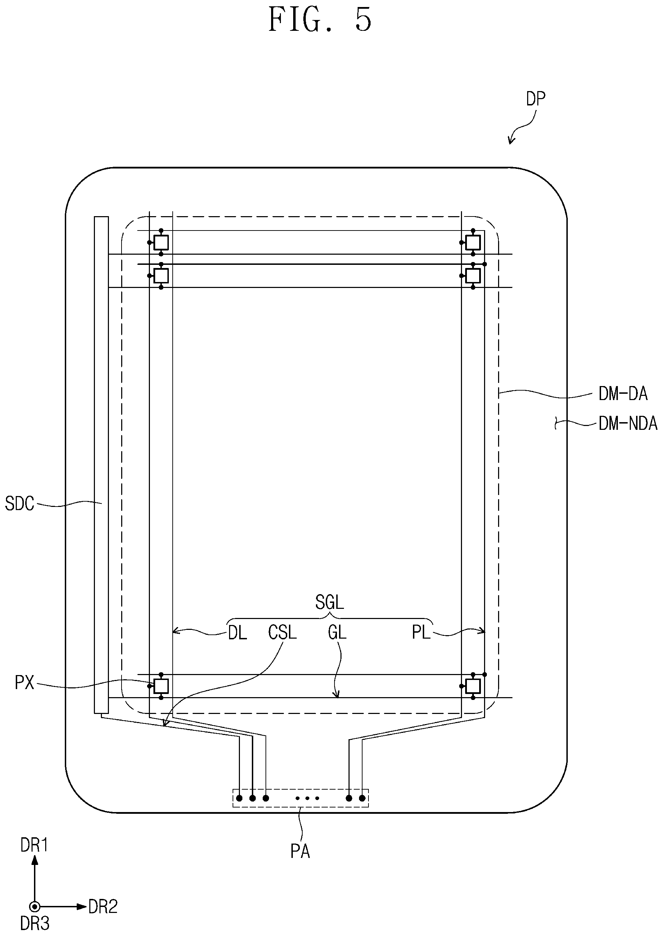

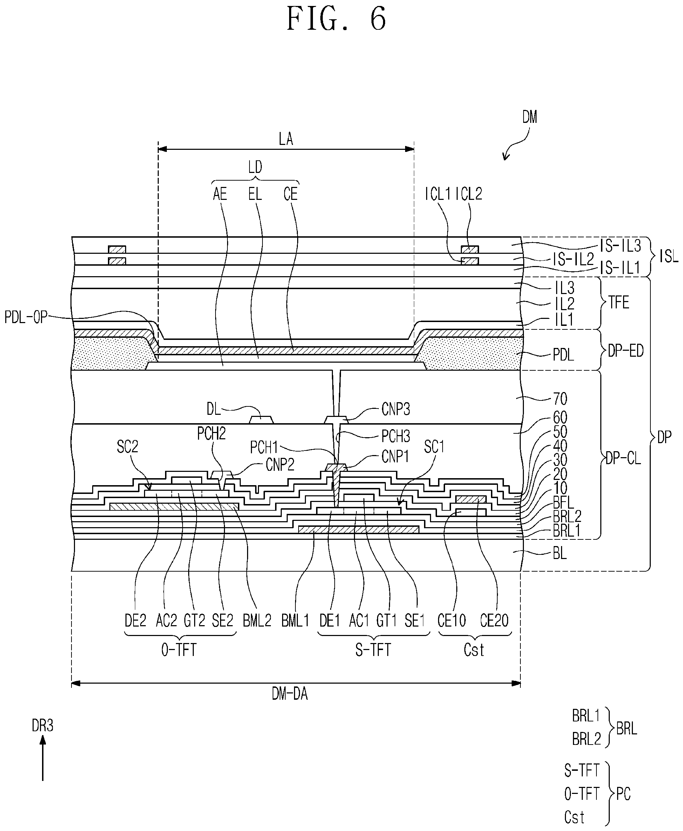

FIG. 5 is a plan view of a display panel. FIG. 6 is a cross-sectional view of the display module.

As illustrated in FIG. 5, the display panel DP may include a scan driving circuit SDC, a plurality of signal lines SGL, and a plurality of pixels PX. The plurality of pixels PX are arranged in the display area DM-DA. Each of the pixels PX includes a light emitting element and a pixel driving circuit connected thereto. The scan driving circuit SDC, the plurality of signal lines SGL, and the pixel driving circuit may be included in the circuit layer DP-CL illustrated in FIG. 4.

The scan driving circuit SDC may include a gate driving circuit. The gate driving circuit generates a plurality of scan signals and sequentially outputs the plurality of scan signals to a plurality of scan lines GL, which will be described below. The scan driving circuit SDC may further include a light emitting driving circuit that is distinguished from the gate driving circuit. The light emitting driving circuit may output scan signals to another group of scan lines.

The scan driving circuit SDC may include a plurality of thin film transistors formed through the same process as that of the pixel driving circuit, for example, a low temperature polycrystalline silicon (LTPS) process or a low temperature polycrystalline oxide (LTPO) process.

The plurality of signal lines SGL include the scan lines GL, data lines DL, a power line PL, and a control signal line CSL. Each of the scan lines GL is connected to a corresponding pixel PX among the plurality of pixels PX, and each of the data lines DL is connected to a corresponding pixel PX among the plurality of pixels PX. The power line PL is connected to the plurality of pixels PX. The data lines DL provide data signals to the pixels PX. The control signal line CSL may provide control signals to the scan driving circuit SDC.

A plurality of power lines PL may be provided. For example, the power line PL may include a first power line that receives a first power voltage and a second power line that receives a second power voltage having a higher level than that of the first power voltage. The first power voltage is provided to the pixels PX through the first power line, and the second power voltage is provided to the pixels PX through the second power line. Although one control signal line CSL is exemplarily illustrated in FIG. 5, a plurality of control signal lines CSL may be provided.

The scan lines GL, the data lines DL, and the power line PL may overlap the display area DM-DA and the non-display area DM-NDA, and the control signal line CSL may overlap the non-display area DM-NDA. Distal ends of the plurality of signal lines SGL may be aligned on one side of the non-display area DM-NDA. The plurality of signal lines SGL may have an integral shape (e.g., a singular uninterrupted structure) but may alternatively include a plurality of parts arranged on different layers. Different parts divided by the insulating layer may be connected through a contact hole passing through the insulating layer. For example, the data lines DL may include a first part disposed in the display area DM-DA and a second part disposed in the non-display area DM-NDA and disposed on a different layer from that of the first part. The first part and the second part may include different materials and have different laminated structures.

The plurality of signal lines SGL may be electrically connected to the main circuit board MCB illustrated in FIG. 3 through the pad area PA.

FIG. 6 illustrates a cross section of the display module DM corresponding to the pixel PX of FIG. 5.

A pixel driving circuit PC that drives a light emitting element LD may include a plurality of pixel driving elements. The pixel driving circuit PC may include a plurality of transistors S-TFT and O-TFT and a capacitor Cst. The plurality of transistors S-TFT and O-TFT may include the silicon transistor S-TFT and the oxide transistor O-TFT. FIG. 6 exemplarily illustrates the silicon transistor S-TFT and the oxide transistor O-TFT. The pixel driving circuit PC of FIG. 6 is merely an example, and the configuration of the pixel driving circuit PC is not necessarily limited thereto. The pixel driving circuit PC may include only one type of transistor among the silicon transistor S-TFT or the oxide transistor O-TFT.

Referring to FIG. 6, the base layer BL is illustrated as a single layer. The base layer BL may include a synthetic resin such as polyimide. The base layer BL may be formed by coating a working substrate (or a carrier substrate) with a synthetic resin layer. When the display module DM is completed through a follow-up process, the working substrate may be removed.

Referring to FIG. 6, a barrier layer BRL may be disposed on the base layer BL. The barrier layer BRL prevents foreign objects from penetrating into lower layers. The barrier layer BRL may include at least one inorganic layer. The barrier layer BRL may include a silicon oxide layer and a silicon nitride layer. Each of the silicon oxide layer and the silicon nitride layer may be provided in plurality and the silicon oxide layers and the silicon nitride layers may be alternately laminated.

The barrier layer BRL may include a lower barrier layer BRL1 and an upper barrier layer BRL2. A first shielding electrode BML1 may be disposed between the lower barrier layer BRL1 and the upper barrier layer BRL2. The first shielding electrode BML1 may correspond to the silicon transistor S-TFT. The first shielding electrode BML1 may include a metal, for example, molybdenum.

The first shielding electrode BML1 may receive a bias voltage. The first shielding electrode BML1 may also receive the first power voltage. The first shielding electrode BML1 may prevent an electrical potential due to a polarization phenomenon from affecting the silicon transistor S-TFT. The first shielding electrode BML1 may prevent external light from reaching the silicon transistor S-TFT. The first shielding electrode BML1 may also be a floating electrode that is isolated from other electrodes or wiring lines.

A buffer layer BFL may be disposed on the barrier layer BRL. The buffer layer BFL may prevent metal atoms or impurities from being diffused from the base layer BL to an upper first semiconductor pattern SC1. The buffer layer BFL may include at least one inorganic layer. The buffer layer BFL may include a silicon oxide layer and a silicon nitride layer.

The first semiconductor pattern SC1 may be disposed on the buffer layer BFL. The first semiconductor pattern SC1 may include a silicon semiconductor. For example, the silicon semiconductor may include amorphous silicon, polycrystalline silicon, and the like. For example, the first semiconductor pattern SC1 may include low-temperature polycrystalline silicon (LTPS).

The first semiconductor pattern SC1 may have different electrical properties depending on whether the first semiconductor pattern SC1 is doped. The first semiconductor pattern SC1 may include a first area having a relatively high conductivity and a second area having a relatively low conductivity. The first area may be doped with an N-type dopant or a P-type dopant. A P-type transistor may include a doped area doped with the P-type dopant, and an N-type transistor may include a doped area doped with the N-type dopant. The second area may be a non-doped area or may be an area doped at a concentration that is lower than that of the first area. The first semiconductor pattern SC1 may be the N-type transistor.

A conductivity of the first area is greater than a conductivity of the second area, and the first area may substantially serve as an electrode or a signal line. The second area may substantially correspond to a channel area (or an active area) of the transistor. For example, a portion of the first semiconductor pattern SC1 may be a channel of the transistor, another portion of the first semiconductor pattern SC1 may be a source or drain of the transistor, and still another portion of the first semiconductor pattern SC1 may be a connection electrode or connection signal line.

A source area SE1, a channel area AC1 (or an active area), and a drain area DE1 of the silicon transistor S-TFT may be formed from the first semiconductor pattern SC1. The source area SE1 and the drain area DE1 may extend in opposite directions from the channel area AC1 on a cross-section.

A first insulating layer 10 may be disposed on the buffer layer BFL. The first insulating layer 10 may cover the first semiconductor pattern SC1. The first insulating layer 10 may be an inorganic layer. The first insulating layer 10 may be a single-layer silicon oxide layer. The first insulating layer 10 as well as the inorganic layer of the circuit layer DP-CL, which will be described below, may have a single-layer or multi-layer structure and include at least one of the above-described materials, but is not necessarily limited thereto.

A gate GT1 of the silicon transistor S-TFT is disposed on the first insulating layer 10. The gate GT1 may be a portion of a metal pattern. The gate GT1 overlaps the channel area AC1. In a process of doping the first semiconductor pattern SC1, the gate GT1 may serve as a mask. A first electrode CE10 of the capacitor Cst is disposed on the first insulating layer 10. Unlike the illustration of FIG. 6, the first electrode CE10 may have an integrated shape with the gate GT1.

A second insulating layer 20 may be disposed on the first insulating layer 10 and may cover the gate GT1. An upper electrode overlapping the gate GT1 may be further disposed on the second insulating layer 20. A second electrode CE20 overlapping the first electrode CE10 may be disposed on the second insulating layer 20. The upper electrode may have an integral shape with the second electrode CE20, for example they may be a single uninterrupted structure.

A second shielding electrode BML2 is disposed on the second insulating layer 20. The second shielding electrode BML2 may correspond to the oxide transistor O-TFT. The second shielding electrode BML2 may be omitted. The first shielding electrode BML1 may extend to a lower portion of the oxide transistor O-TFT and replace the second shielding electrode BML2.

A third insulating layer 30 may be disposed on the second insulating layer 20. A second semiconductor pattern SC2 may be disposed on the third insulating layer 30. The second semiconductor pattern SC2 may include a channel area AC2 of the oxide transistor O-TFT. The second semiconductor pattern SC2 may include a metal oxide semiconductor. The second semiconductor pattern SC2 may include a transparent conductive oxide (TCO) such as indium tin oxide (ITO), indium zinc oxide (IZO), indium gallium zinc oxide (IGZO), zinc oxide (ZnOₓ), or indium oxide (In₂O₃).

The metal oxide semiconductor may include a plurality of areas SE2, AC2, and DE2 divided according to whether the TCO is reduced. An area (hereinafter, referred to as a reduced area), in which the TCO is reduced, has higher conductivity than that of an area (hereinafter, a non-reduced area), in which the TCO is not reduced. The reduced area substantially serves as a source/drain of a transistor or a signal line. The non-reduced area substantially corresponds to a semiconductor area (or a channel) of the transistor. For example, a partial area of the second semiconductor pattern SC2 may be the semiconductor area of the transistor, another partial area thereof may be the source area SE2/the drain area DE2 of the transistor, and still another partial area thereof may be a signal transmission area.

A fourth insulating layer 40 may be disposed on the third insulating layer 30. As illustrated in FIG. 6, the fourth insulating layer 40 may cover the second semiconductor pattern SC2. The fourth insulating layer 40 may be an insulating pattern that overlaps a gate GT2 of the oxide transistor O-TFT and exposes the source area SE2 and the drain area DE2 of the oxide transistor O-TFT.

The gate GT2 of the oxide transistor O-TFT is disposed on the fourth insulating layer 40. The gate GT2 of the oxide transistor O-TFT may be a portion of the metal pattern. The gate GT2 of the oxide transistor O-TFT overlaps the channel area AC2.

A fifth insulating layer 50 may be disposed on the fourth insulating layer 40, and the fifth insulating layer 50 may cover the gate GT2. Each of the first insulating layer 10 to the fifth insulating layer 50 may be an inorganic layer.

A first connection pattern CNP1 and a second connection pattern CNP2 may be arranged on the fifth insulating layer 50. The first connection pattern CNP1 and the second connection pattern CNP2 may be formed through the same process and thus may be comprised of the same material and may be part of the same laminated structure. The first connection pattern CNP1 may be connected to the drain area DE1 of the silicon transistor S-TFT through a first pixel contact hole PCH1 passing through the first to fifth insulating layers 10, 20, 30, 40, and 50. The second connection pattern CNP2 may be connected to the source area SE2 of the oxide transistor O-TFT through a second pixel contact hole PCH2 passing through the fourth and fifth insulating layers 40 and 50. The connection relationship between the first connection pattern CNP1 and the second connection pattern CNP2 for the silicon transistor S-TFT and the oxide transistor O-TFT is not necessarily limited thereto.

A sixth insulating layer 60 may be disposed on the fifth insulating layer 50. A third connection pattern CNP3 may be disposed on the sixth insulating layer 60. The third connection pattern CNP3 may be connected to the first connection pattern CNP1 through a third pixel contact hole PCH3 passing through the sixth insulating layer 60. The data line DL may be disposed on the sixth insulating layer 60. A seventh insulating layer 70 may be disposed on the sixth insulating layer 60 and cover the third connection pattern CNP3 and the data line DL. The third connection pattern CNP3 and the data line DL may be formed through the same process and thus may be comprised of the same material and may be part of the same laminated structure. Each of the sixth insulating layer 60 and the seventh insulating layer 70 may be an organic layer.

The first shielding electrode BML1, the gate GT1 of the silicon transistor S-TFT, the second electrode CE20, and the gate GT2 of the oxide transistor O-TFT may include molybdenum (Mo), an alloy containing molybdenum, titanium (Ti), or an alloy containing titanium, which have excellent heat resistance. The first connection pattern CNP1 and the second connection pattern CNP2 may include aluminum, which has high electrical conductivity. The first connection pattern CNP1 and the second connection pattern CNP2 may have a three-layer structure in which titanium/aluminum/titanium are laminated.

The light emitting element LD may include an anode AE (or a first electrode), a light emitting layer EL, and a cathode CE (or a second electrode). The anode AE of the light emitting element LD may be disposed on the seventh insulating layer 70. The anode AE may be a transmissive electrode, a semi-transmissive electrode, or a reflective electrode. The anode AE may include a laminated structure in which ITO/Ag/ITO are sequentially laminated. The positions of the anode AE and the cathode CE may be changed to each other.

A pixel defining film PDL may be disposed on the seventh insulating layer 70. The pixel defining film PDL may be an organic layer. The pixel defining film PDL may have a property of absorbing light, and for example, the pixel defining film PDL may have a black color. The pixel defining film PDL may include a black coloring agent. The black coloring agent may include black dye and/or black pigment. The black coloring agent may include carbon black, metal such as chromium, or an oxide thereof. The pixel defining film PDL may correspond to a light shielding pattern having light shielding characteristics.

The pixel defining film PDL may cover a portion of the anode AE. For example, an opening PDL-OP, through which the portion of the anode AE is exposed, may be defined in the pixel defining film PDL. A light emitting area LA may be defined to correspond to the opening PDL-OP. A hole control layer may be disposed between the anode AE and the light emitting layer EL. The hole control layer may include a hole transport layer and may further include a hole injection layer. An electron control layer may be disposed between the light emitting layer EL and the cathode CE. The electron control layer may include an electron transport layer and may further include an electron injection layer.

The encapsulation layer TFE may cover the light emitting element LD. The encapsulation layer TFE may include a first encapsulation insulating layer IL1, a second encapsulation insulating layer IL2, and a third encapsulation insulating layer IL3. However, the present disclosure is not necessarily limited thereto, and the encapsulation layer TFE may further include a plurality of inorganic layers and a plurality of organic layers.

The first encapsulation insulating layer IL1 may be an inorganic layer. The first encapsulation insulating layer IL1 may prevent external moisture or oxygen from penetrating into the light emitting element LD. For example, the first encapsulation insulating layer IL1 may include silicon nitride, silicon oxide, or a compound obtained by combining them. The first encapsulation insulating layer IL1 may be formed through a chemical vapor deposition process.

The second encapsulation insulating layer IL2 may be an organic layer. The second encapsulation insulating layer IL2 may be disposed on the first encapsulation insulating layer IL1 and may be in contact with the first encapsulation insulating layer IL1. The second encapsulation insulating layer IL2 may provide a flat surface onto the first encapsulation insulating layer IL1. Curves formed in an upper surface of the first encapsulation insulating layer IL1 and particles present on the first encapsulation insulating layer IL1 are covered by the second encapsulation insulating layer IL2, and thus a surface condition of the upper surface of the first encapsulation insulating layer IL1 may be prevented from affecting components formed on the second encapsulation insulating layer IL2. Further, the second encapsulation insulating layer IL2 may alleviate stresses between contact layers. The second encapsulation insulating layer IL2 may be formed through a solution process such as spin coating, slit coating, and an inkjet process.

The third encapsulation insulating layer IL3 is disposed on the second encapsulation insulating layer IL2 and covers the second encapsulation insulating layer IL2. The third encapsulation insulating layer IL3 may be stably formed on a relatively flat surface as compared to a state in which the third encapsulation insulating layer IL3 is disposed on the first encapsulation insulating layer IL1. The third encapsulation insulating layer IL3 encapsulates moisture released from the second encapsulation insulating layer IL2 and thus prevents external moisture from being introduced.

The third encapsulation insulating layer IL3 may be optically transparent. For example, the third encapsulation insulating layer IL3 may have a visible light transmittance of about 90% or more. The third encapsulation insulating layer IL3 may have a relatively high light transmittance as compared to the first encapsulation insulating layer IL1. The third encapsulation insulating layer IL3 may be an inorganic layer. The third encapsulation insulating layer IL3 may include silicon oxide (SiOₓ) or silicon oxy nitride (SiON). The third encapsulation insulating layer IL3 may be formed through a chemical vapor deposition process. Each of the first encapsulation insulating layer IL1, the second encapsulation insulating layer IL2, and the third encapsulation insulating layer IL3 may include a plurality of layers, but are not limited thereto.

The input sensing layer ISL may include at least one conductive layer (or at least one sensor-conductive layer) and at least one insulating layer (or at least one sensor insulating layer). The input sensing layer ISL may include a first sensing insulating layer IS-IL1, a first conductive layer ICL1, a second insulating layer IS-IL2, a second conductive layer ICL2, and a third insulating layer IS-IL3. FIG. 6 briefly illustrates a conductive line of the first conductive layer ICL1 and a conductive line of the second conductive layer ICL2.

The first sensing insulating layer IS-IL1 may be directly disposed on the display panel DP. The first sensing insulating layer IS-IL1 may be an inorganic layer including silicon nitride, silicon oxy nitride, and/or silicon oxide. Each of the first conductive layer ICL1 and the second conductive layer ICL2 may have a single-layer structure or have a multi-layer structure in which layers are laminated in the third direction DR3. The first conductive layer ICL1 and the second conductive layer ICL2 may include conductive lines that define a meshshaped electrode. The conductive line of the first conductive layer ICL1 and the conductive line of the second conductive layer ICL2 may or might not be connected through a contact hole passing through the second insulating layer IS-IL2. A connection relationship between the conductive line of the first conductive layer ICL1 and the conductive line of the second conductive layer ICL2 may be determined depending on the type of sensor formed in the input sensing layer ISL.

The first conductive layer ICL1 and the second conductive layer ICL2 having a single-layer structure may include a metal layer or a transparent conductive layer. The metal layer may include molybdenum, silver, titanium, copper, aluminum, or alloys thereof. The transparent conductive layer may include a transparent conductive oxide such as indium tin oxide (ITO), indium zinc oxide (IZO), zinc oxide (ZnOₓ), or indium zinc tin oxide (IZTO). In addition, the transparent conductive layer may include a conductive polymer such as poly(3,4-ethylenedioxythiophene) (PEDOT), metal nanowire, graphene, or the like.

The first conductive layer ICL1 and the second conductive layer ICL2 having a multi-layer structure may include metal layers. The metal layers may have, for example, a three-layer structure of titanium/aluminum/titanium. The first conductive layer ICL1 and the second conductive layer ICL2 having a multi-layer structure may include at least one metal layer and at least one transparent conductive layer. The second insulating layer IS-IL2 may be disposed between the first conductive layer ICL1 and the second conductive layer ICL2. The third insulating layer IS-IL3 may cover the second conductive layer ICL2. The third insulating layer IS-IL3 may be omitted. The second insulating layer IS-IL2 and the third insulating layer IS-IL3 may include an inorganic layer or an organic layer.

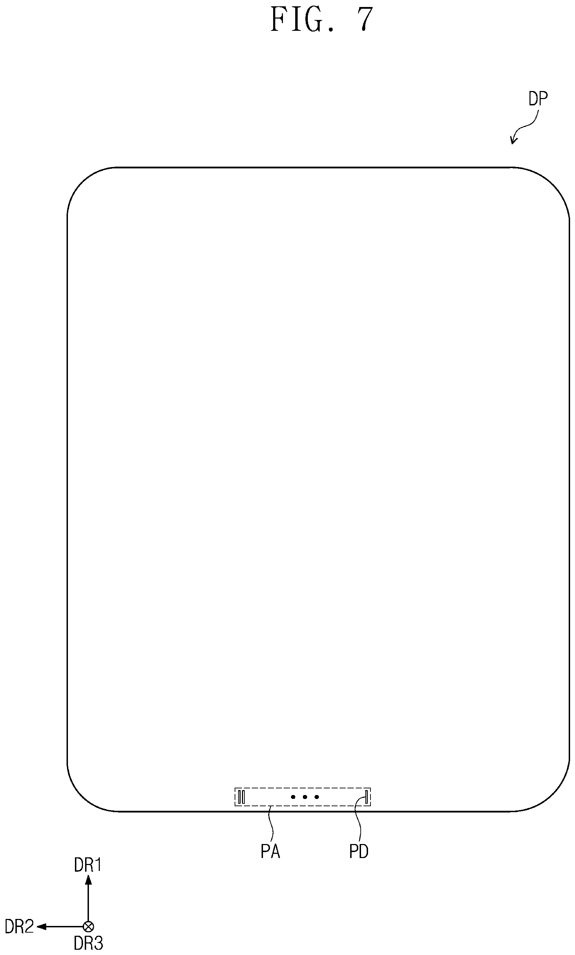

FIG. 7 is a plan view of a display panel. FIG. 7 is a plan view of the display panel DP when viewed from the third direction DR3.

Referring to FIG. 7, pad electrodes PD may be arranged on the rear surface of the display panel DP. For example, the pad electrodes PD may be arranged on the pad area PA. The pad electrodes PD may be arranged in the second direction DR2.

The plurality of signal lines SGL (see FIG. 5) arranged on the display panel DP may be electrically connected to the flexible circuit board FCB illustrated in FIG. 3 through the pad area PA. For example, the plurality of signal lines SGL may be arranged in the pad area PA and connected to the pad electrodes PD spaced apart from each other in the first direction DR1 through a connection electrode or the like. The pad electrodes PD may be arranged on the rear surface of the display panel DP and electrically connected to the flexible circuit board FCB (see FIG. 2). A detailed description in which the flexible circuit board FCB and the plurality of signal lines SGL are connected will be made below.

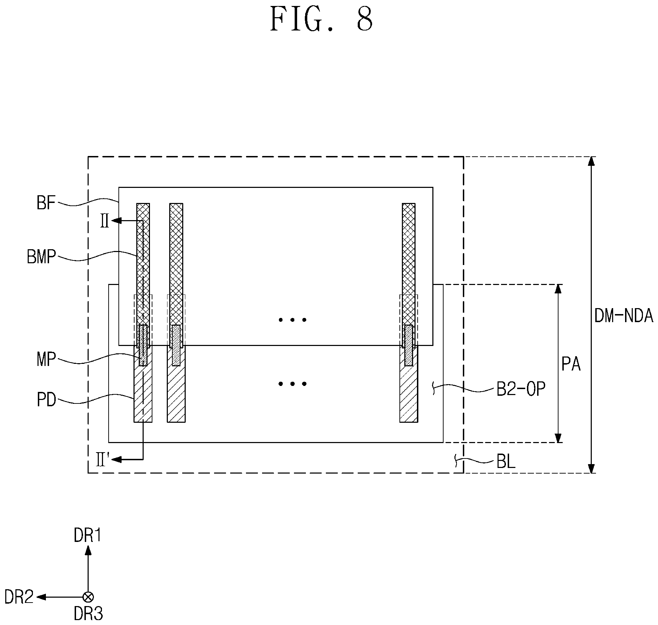

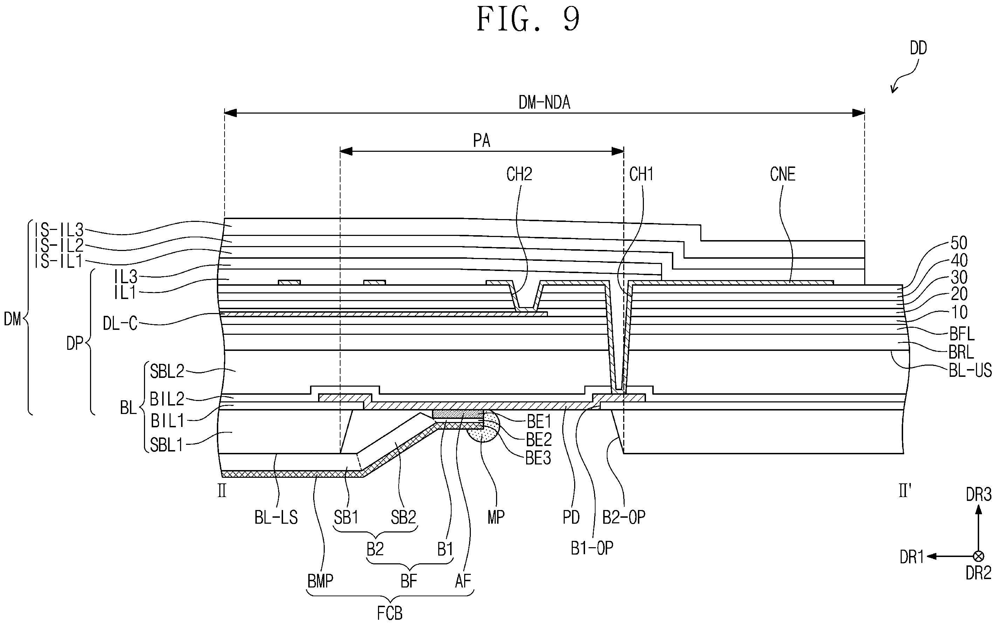

FIG. 8 is an enlarged plan view illustrating a portion of the display device. FIG. 9 is a cross-sectional view of the display device along line II-II' of FIG. 8. FIGS. 8 and 9 are view illustrating a state in which the flexible circuit board FCB is attached to the display panel DP. Hereinafter, to the extent that an element is not described in detail with respect to this figure, it may be understood that the element is at least similar to a corresponding element that has been described elsewhere within the present disclosure.

Referring to FIGS. 8 and 9, the display device DD may include a connection electrode CNE and the plurality of pad electrodes PD. The connection electrode CNE is disposed on the same layer as that of the first connection pattern CNP1 illustrated in FIG. 6, and a portion of a data connection line DL-C overlapping the non-display area DM-NDA is disposed on the same layer as that of the gate GT1 of the silicon transistor S-TFT in FIG. 6. The data connection line DL-C may be electrically connected to the data line DL in FIG. 6.

The pad electrodes PD may be exposed through a lower surface BL-LS of the base layer BL for rear surface bonding with the flexible circuit board FCB. However, the present disclosure is not necessarily limited thereto, and the pad electrodes PD might not be exposed directly but may be exposed through a contact hole or the like. The lower surface BL-LS of the base layer BL faces an upper surface BL-US of the base layer BL in the third direction DR3.

The base layer BL may include a first sub-base layer SBL1, a first base insulating layer BIL1, a second base insulating layer BIL2, and a second sub-base layer SBL2. The first base insulating layer BIL1 is disposed on the first sub-base layer SBL1, and the second base insulating layer BIL2 is disposed on the first base insulating layer BIL1 and covers the pad electrodes PD. The second sub-base layer SBL2 is disposed on the second base insulating layer BIL2.

The first sub-base layer SBL1 and the second sub-base layer SBL2 may include a synthetic resin material, for example, polyimide. The first base insulating layer BIL1 and the second base insulating layer BIL2 may include an inorganic material. For example, the first base insulating layer BIL1 and the second base insulating layer BIL2 may include silicon nitride, silicon oxy nitride, or silicon oxide.

The first base insulating layer BIL1 is disposed on the first sub-base layer SBL1, and a first opening B1-OP, through which portions of the pad electrodes PD are exposed, is defined in the first base insulating layer BIL1. The first sub-base layer SBL1 may be disposed under the first base insulating layer BIL1. The first sub-base layer SBL1 provides the lower surface BL-LS of the base layer BL, and a second opening B2-OP, through which the pad electrodes PD are exposed to the outside of the display module DM, is defined in the first sub-base layer SBL1. The second opening B2-OP may expose a portion of the first base insulating layer BIL1. A size of the second opening B2-OP is larger than a size of the first opening B1-OP.

The pad electrodes PD may be embedded in the base layer BL. For example, in an embodiment, the base layer BL may include the pad electrodes PD that are exposed through the first opening B1-OP and the second opening B2-OP. However, the present disclosure is not necessarily limited thereto, and the pad electrodes PD may be arranged on the lower surface BL-LS of the base layer BL. Even when the base layer BL includes a single-layer synthetic resin layer or a plurality of layers, the first opening B1-OP and the second opening B2-OP, which will be described below, might not be defined. The pad electrodes PD arranged on the lower surface BL-LS of the base layer BL may be connected to a conductive pattern disposed on the upper surface BL-US of the base layer BL through a contact hole passing through the base layer BL.

The connection electrode CNE may be connected to the pad electrodes PD through a first contact hole CH1 and connected to the data connection line DL-C through a second contact hole CH2. The first contact hole CH1 and the second contact hole CH2 may be arranged in the non-display area DM-NDA. The first contact hole CH1 may be formed by passing through portions of the plurality of insulating layers 10 to 50, the barrier layer BRL, the buffer layer BFL, and the base layer BL. The first contact hole CH1 may be connected to the pad electrodes PD through the second base insulating layer BIL2 and the second sub-base layer SBL2 of the base layer BL. The second contact hole CH2 may be formed by passing through the second insulating layer 20 to the fifth insulating layer 50. The connection electrode CNE may be connected to the data line DL through the second contact hole CH2.

The pad electrodes PD may extend in the first direction DR1 and be arranged in the second direction DR2. The shape and arrangement of the pad electrodes PD are not necessarily limited to the above illustration. The pad electrodes PD may overlap the non-display area DM-NDA. For example, the pad electrodes PD may be arranged on the pad area PA.

The flexible circuit board FCB may include a base film BF and a bump electrode BMP disposed under the base film BF. The flexible circuit board FCB may be attached to the display panel DP in a bent state on the rear surface of the display panel DP. An adhesive layer may be disposed between the flexible circuit board FCB and the lower surface BL-LS of the base layer BL to fix the flexible circuit board FCB to the lower surface BL-LS of the base layer BL.

The base film BF may include a first part B1 and a second part B2 having different thicknesses. For example, a thickness of the second part B2 may be greater than a thickness of the first part B1. The first part B1 may overlap the pad electrodes PD on a plane (e.g., in a plan view). The first part B1 may be disposed parallel to the pad electrodes PD with respect to a plane defined by the first direction DR1 and the second direction DR2. The second part B2 may include a first sub-portion SB1 parallel to the base layer BL and a second sub-portion SB2 extending from the first sub-portion SB1 and including an inclined surface formed toward the second opening B2-OP with respect to the first sub-portion SB1. The first part B1 and the second part B2 may be formed integrally, for example, as a single uninterrupted structure. For example, the second sub-portion SB2 may be disposed between the first sub-portion SB1 and the first part B1 and formed by integrally connecting the first sub-portion SB1 and the first part B1. The base film BF may include a synthetic resin material, for example, polyimide.

The bump electrode BMP may be arranged on a lower surface of the base film BF. The bump electrode BMP may be disposed on a lower surface of the first part B1 of the base film BF. However it is not necessarily limited thereto, and as illustrated, the bump electrode BMP may be disposed on lower surfaces of the first part B1 and the second part B2.

The bump electrode BMP may overlap the pad electrodes PD on a plane (e.g., in a plan view). The bump electrode BMP may be in contact with and electrically connected to the pad electrodes PD. A plurality of bump electrodes BMP may be provided. The plurality of bump electrodes BMP may correspond to the plurality of pad electrodes PD. For example, one bump electrode BMP may correspond to one pad electrode PD. The bump electrodes BMP may extend in the first direction DR1 and be arranged in the second direction DR2. An area of the pad electrodes PD on a plane (e.g., in a plan view) may be larger than an area of the bump electrodes BMP on a plane (e.g., in a plan view).

The base film BF may include a bending structure. For example, a space between the first sub-portion SB1 and the second sub-portion SB2 may be bent toward the second opening B2-OP, and a space between the second sub-portion SB2 and the first part B1 may be bent in parallel to the pad electrodes PD. Accordingly, the bump electrodes BMP arranged in direct contact with the base film BF may also include the same bending structure as that of the base film BF.

An adhesive layer AF may be disposed between the base film BF and the pad electrodes PD. For example, the adhesive layer AF may be disposed between the first part B1 and the pad electrodes PD. The adhesive layer AF may include a non-conductive material. For example, the adhesive layer AF may include a non-conductive film. A thickness of the adhesive layer AF may be greater than a thickness of the first part B1.

An edge of the adhesive layer AF may be defined as a first edge BE1, an edge of the base film BF may be defined as a second edge BE2, and an edge of the bump electrodes BMP may be defined as a third edge BE3. In an embodiment, an edge of the first part Blot the base film BF may be defined as a second edge BE2. The first edge BE1, the second edge BE2, and the third edge BE3 may be aligned in parallel with respect to the third direction DR3. However, the arrangement is not necessarily limited to the above illustration, and only the second edge BE2 and the third edge BE3 may be aligned in parallel with respect to the third direction DR3.

The bump electrodes BMP arranged on the first part B1 may be electrically connected to the pad electrodes PD arranged under the first part B1. For example, the display device DD may further include a metal pattern MP that electrically connects the bump electrodes BMP and the pad electrodes PD. The metal pattern MP is disposed on the pad electrodes PD and the bump electrodes BMP and electrically connects the pad electrodes PD and the bump electrodes BMP. A plurality of metal patterns MP may correspond to the pad electrodes PD and the bump electrodes BMP. In an embodiment, the metal pattern MP may electrically connect the display panel and the circuit board to each other.

Each of the metal patterns MP may be a pattern in which a metal ink is cured. The metal patterns MP may include solder paste. The metal patterns MP may be formed of a metal ink containing silver or copper. The metal patterns MP may be arranged in the pad electrodes PD, respectively.

The metal patterns MP may be formed by curing and then patterning the metal ink. The metal pattern MP may be formed at a low temperature and may electrically connect, and at the same time, bond the pad electrodes PD and the bump electrodes BMP without a process of pressing at a high temperature. A process of forming the metal patterns MP will be described below.

In a display device DD the bump electrodes BMP may be directly arranged on the lower surface of the first part B1 having a smaller thickness than that of the second part B2 and electrically connected with the pad electrodes PD by the metal patterns MP. As the bump electrodes BMP are directly arranged on a lower surface of the first part B1, in a process of arranging the flexible circuit board FCB such that the flexible circuit board FCB faces the pad electrodes PD, a phenomenon in which the bump electrodes BMP are bent in the second direction DR2 or lifted up in the third direction DR3 may be prevented. As a result, defects due to the alignment between the bump electrodes BMP and the pad electrodes PD may be prevented, and thus the display device DD having increased reliability may be provided.

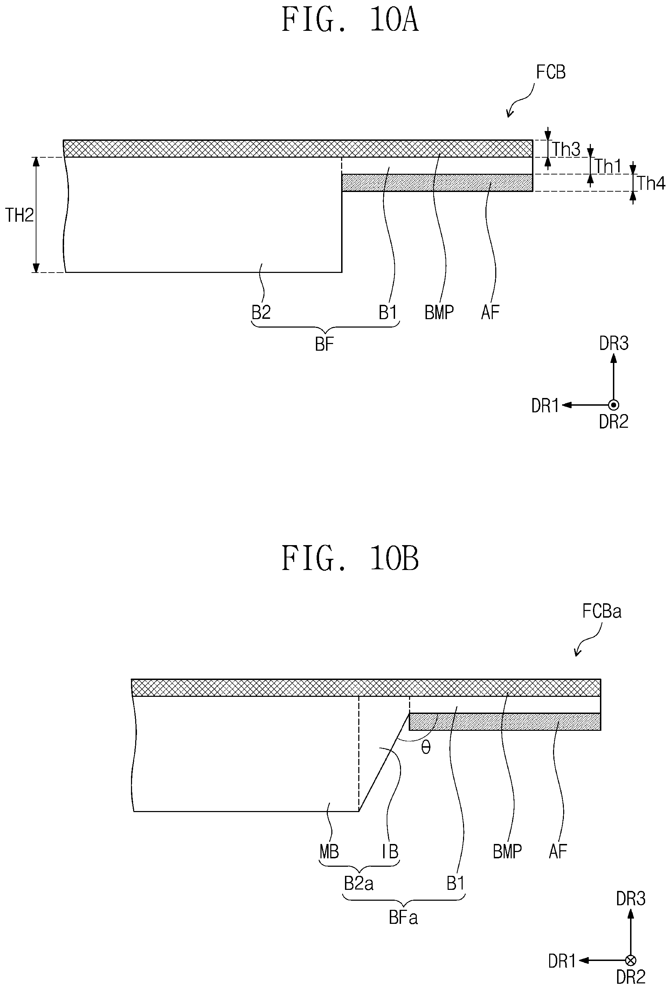

FIG. 10A is a cross-sectional view of a flexible circuit board. FIG. 10B is a cross-sectional view of the flexible circuit board. FIGS. 10A and 10B illustrate the flexible circuit boards FCB and FCBa before bending unlike the bent flexible circuit board FCB illustrated in FIG. 9 and illustrate the bent flexible circuit board FCB illustrated in FIG. 9 in an upside down orientation.

Referring to FIG. 10A, the flexible circuit board FCB may include the base film BF, the bump electrode BMP disposed on the base film BF, and the adhesive layer AF disposed under the base film BF.

The base film BF may include the first part B1 and the second part B2 having different thicknesses. The first part B1 may have a first thickness Th1, and the second part B2 may have a second thickness Th2. The second thickness Th2 may be greater than the first thickness Th1. The first thickness Th1 may be within a range of about 3% to about 20% of the second thickness Th2. For example, the second thickness Th2 may be within a range of about 30 to about 40 µm, and the first thickness Th1 may be within a range of about 1 µm to about 7 µm.

The bump electrode BMP may be disposed on the base film BF. As illustrated, the bump electrode BMP may be disposed on the first part B1 and the second part B2 of the base film BF. However, the arrangement is not necessarily limited thereto, and the bump electrode BMP may be disposed only on the first part B1. The thickness of the bump electrode BMP may be defined as a third thickness Th3. The third thickness Th3 may be greater than the first thickness Th1. For example, the third thickness Th3 may be within a range of about 8 µm to about 10 µm.

The adhesive layer AF may be disposed under the base film BF. For example, the adhesive layer AF may be disposed under the first part B1 of the base film BF. The thickness of the adhesive layer AF may be defined as a fourth thickness Th4. The fourth thickness Th4 may be greater than the first thickness Th1 and the third thickness Th3. For example, the fourth thickness Th4 may be within a range of about 12 µm to about 18 µm.

Referring to FIG. 10B, the flexible circuit board FCBa may include a base film BFa, the bump electrode BMP disposed on the base film BFa, and the adhesive layer AF disposed under the base film BFa. The base film BFa may include the first part B1 and a second part B2a having different thicknesses. The second part B2a may include a main portion MB having a uniform thickness and an inclined portion IB of which a thickness gradually decreases. The thickness of the inclined portion IB may gradually decrease toward the first part B1. The inclined portion IB may be adjacent to the first part B1. For example, the inclined portion IB may be between the main portion MB and the first part B1 and may be formed by integrally connecting the main portion MB and the first part B1.

An angle formed between the first part B1 and the second part B2a may be an obtuse angle. For example, an angle formed between the first part B1 and the inclined portion IB of the second part B2a may be an obtuse angle. The angle formed between the first part B1 and the inclined portion IB of the second part B2a may be defined as a first angle θ. The first angle θ may be within a range of about 100° to about 170°.

Referring to FIGS. 9 and 10B, the flexible circuit board FCBa may be disposed on the rear surface of the display panel DP. In this case, the flexible circuit board FCBa may be bent between the first part B1 and the second part B2a and attached to the rear surface of the display panel DP. As the first angle θ formed between the first part B1 and the second part B2a is within a range of about 100° to about 170°, a compressive stress or tensile stress that occurs when the flexible circuit board FCBa is bent may be distributed to prevent deformation of the flexible circuit board FCBa.

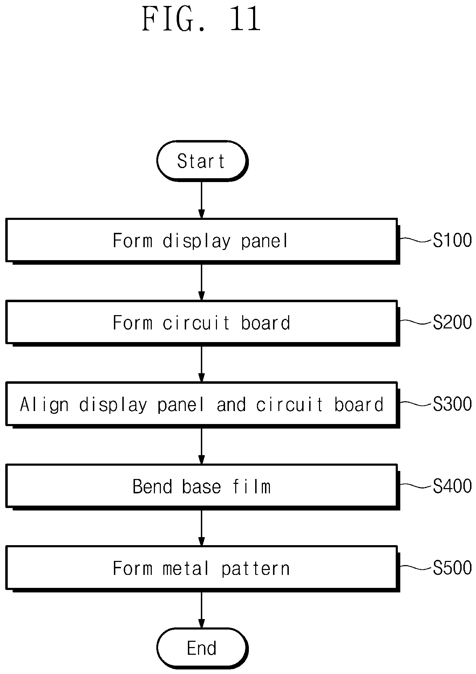

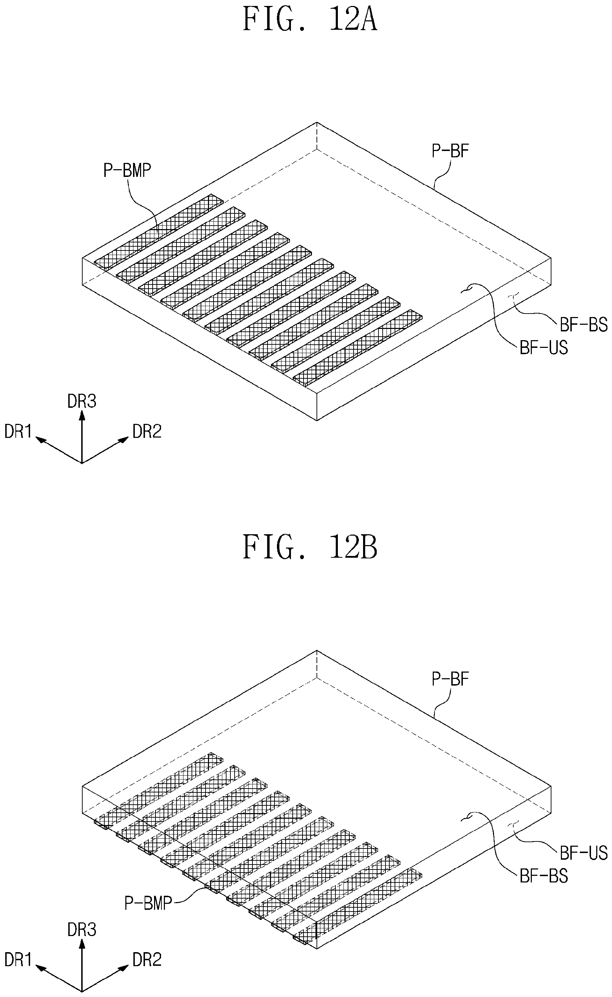

FIG. 11 is a flowchart illustrating a method of manufacturing a display device. FIGS. 12A to 14B are views illustrating some operations of the method of manufacturing a display device. Hereinafter, a method of manufacturing the display device DD will be described with reference to FIGS. 11 to 14B.

Referring to FIGS. 11 to 14B, the method of manufacturing the display device DD may include operation S100 of forming the display panel DP, operation S200 of forming the flexible circuit board (or circuit board) FCB, operation S300 of aligning the display panel DP and the flexible circuit board FCB, operation S400 of bending the base film BF, and operation S500 of forming the metal pattern MP. The display panel DP, the flexible circuit board FCB, and the metal pattern MP may include the same configurations as those of the display panel DP, the flexible circuit board FCB, and the metal pattern MP illustrated in FIG. 9.

FIGS. 12A to 12F are views illustrating operation S200 (see FIG. 1) of forming the flexible circuit board FCB.

Referring to FIGS. 12A and 12B, an operation of providing a preliminary base film P-BF and preliminary bump electrodes P-BMP on an upper surface BF-US of the preliminary base film P-BF and an operation of inverting the preliminary base film P-BF and the preliminary bump electrodes P-BMP may be performed.

The preliminary base film P-BF may include a synthetic resin material, for example, polyimide. The preliminary bump electrodes P-BMP on the preliminary base film P-BF may be formed by patterning an integrally formed metal portion. As a result, a plurality of preliminary bump electrodes P-BMP may be formed on the upper surface BF-US of the preliminary base film P-BF. Further, an adhesive including conductivity or the like may be disposed between the preliminary base film P-BF and the preliminary bump electrodes P-BMP. Accordingly, the preliminary base film P-BF and the preliminary bump electrodes P-BMP may be fixedly attached to each other.

After the preliminary base film P-BF and the preliminary bump electrodes P-BMP are formed, an operation of inverting the preliminary base film P-BF upside down may be performed. For example, a lower surface BF-BS of the preliminary base film P-BF, which faces the upper surface BF-US of the preliminary base film P-BF, may face the third direction DR3. Since the preliminary base film P-BF and the preliminary bump electrodes P-BMP are fixedly attached to each other, even when the preliminary base film P-BF is inverted upside down, the preliminary bump electrodes P-BMP may be attached to the preliminary base film P-BF and might not be separated therefrom.

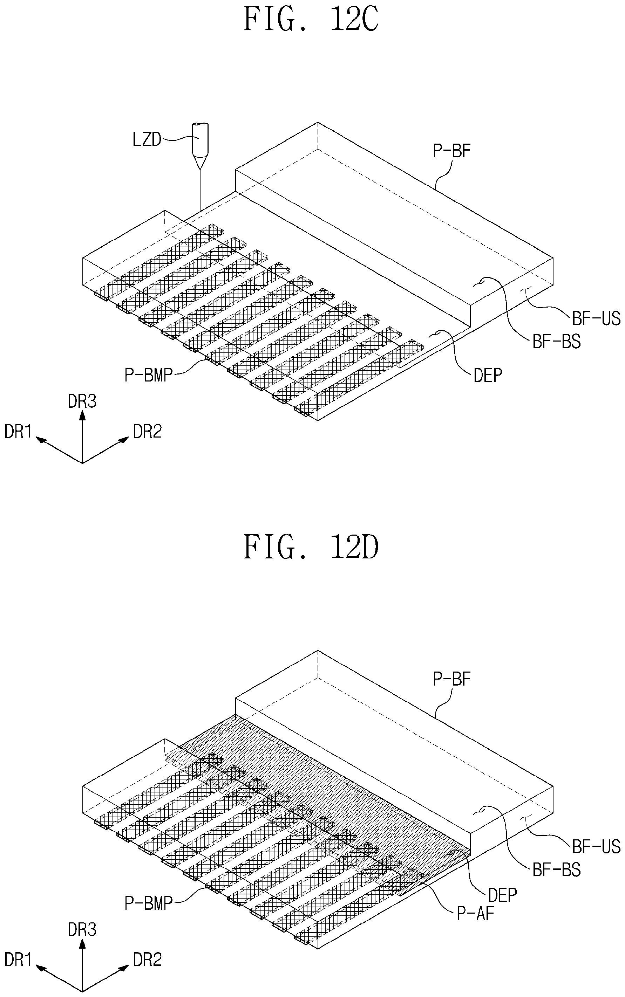

Referring to FIG. 12C, a depression DEP may be formed on the lower surface BF-BS of the preliminary base film P-BF. The depression DEP may be formed by etching using a laser device LZD. The depression DEP may be formed by irradiating the lower surface BF-BS of the preliminary base film P-BF with a laser emitted from the laser device LZD and etching the preliminary base film P-BF. The laser device LZD may move in the first direction DR1 and etch the preliminary base film P-BF. As a result, the depression DEP may extend in the first direction DR1. A depth of the depression DEP in the third direction DR3 may be within a range of about 80% to about 97% of the preliminary base film P-BF. It is illustrated that the depression DEP is perpendicular to the lower surface BF-BS, but the present disclosure is not necessarily limited thereto, and the depression DEP may be inclined with respect to the lower surface BF-BS.

Referring to FIG. 12D, an operation of arranging a preliminary adhesive layer P-AF in the depression DEP of the preliminary base film P-BF may be performed. A width of the preliminary adhesive layer P-AF in the second direction DR2 may be the same as a width of the depression DEP in the second direction DR2. A thickness of the preliminary adhesive layer P-AF in the third direction DR3 may be smaller than a depth of the depression DEP.

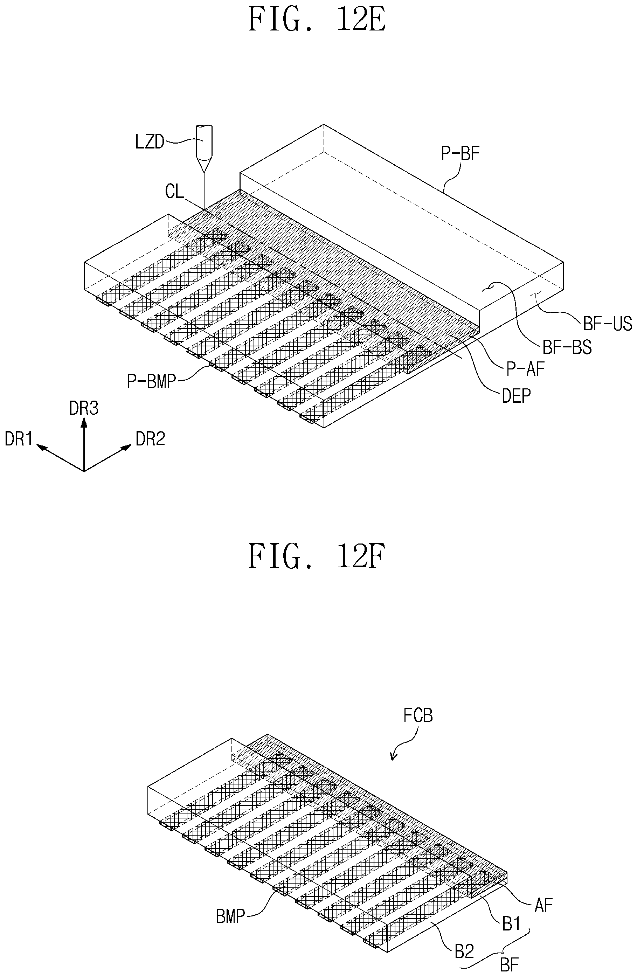

Referring to FIGS. 12E and 12F, an operation of forming the flexible circuit board FCB may be performed by cutting the preliminary base film P-BF, the preliminary adhesive layer P-AF, and the preliminary bump electrodes P-BMP. The preliminary base film P-BF, the preliminary adhesive layer P-AF, and the preliminary bump electrodes P-BMP may be cut with respect to a cutting line CL parallel to the first direction DR1 and overlapping the depression DEP on a plane (e.g., in a plan view). The operation of cutting the preliminary base film P-BF, the preliminary adhesive layer P-AF, and the preliminary bump electrodes P-BMP may be performed using the laser device LZD. The laser device LZD may move in the first direction DR1 and cut the preliminary base film P-BF, the preliminary adhesive layer P-AF, and the preliminary bump electrodes P-BMP along the cutting line CL. As a result, the flexible circuit board FCB including the base film BF, the bump electrodes BMP arranged under the base film BF, the bump electrodes BMP arranged on the base film BF, and the adhesive layer AF may be provided. The base film BF may include the first part B1 and the second part B2 having different thicknesses. The thickness of the second part B2 may be greater than the thickness of the first part B1.

Referring to FIGS. 12A to 12F, in the operation of forming the flexible circuit board FCB, the bump electrodes BMP may be arranged and formed on the first part B1. As a result, as compared to a case in which the bump electrodes BMP are not arranged on the first part B1, the first part B1 is removed, and the bump electrodes BMP are exposed, a process of removing the first part B1 is omitted, and thus a process of forming the flexible circuit board FCB may be simplified.

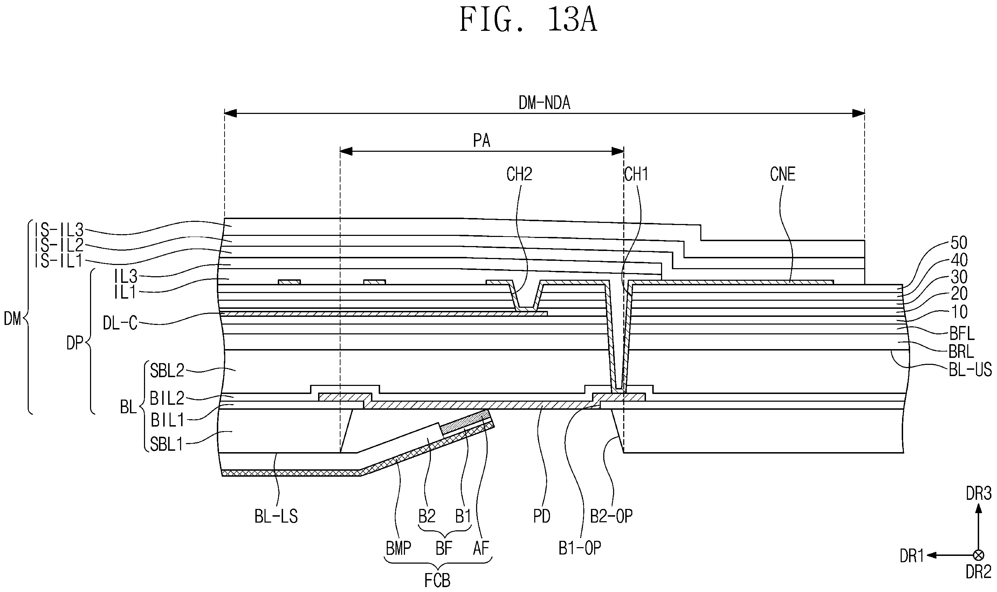

FIG. 13A is a cross-sectional view illustrating operation S300 (see FIG. 11) of aligning the display panel DP and the flexible circuit board FCB.

Referring to FIG. 13A, the flexible circuit board FCB may be disposed under the display panel DP. For example, the flexible circuit board FCB may be disposed on the lower surface BL-LS of the base layer BL of the display panel DP. The flexible circuit board FCB may be disposed on the second opening B2-OP of the base layer BL. For example, portions of the flexible circuit board FCB, which overlap the first part B1, may be arranged in the second opening B2-OP. The adhesive layer AF of the flexible circuit board FCB may be in direct contact with the pad electrodes PD. When viewed in the third direction DR3, the first part B1 and the pad electrodes PD may face each other.

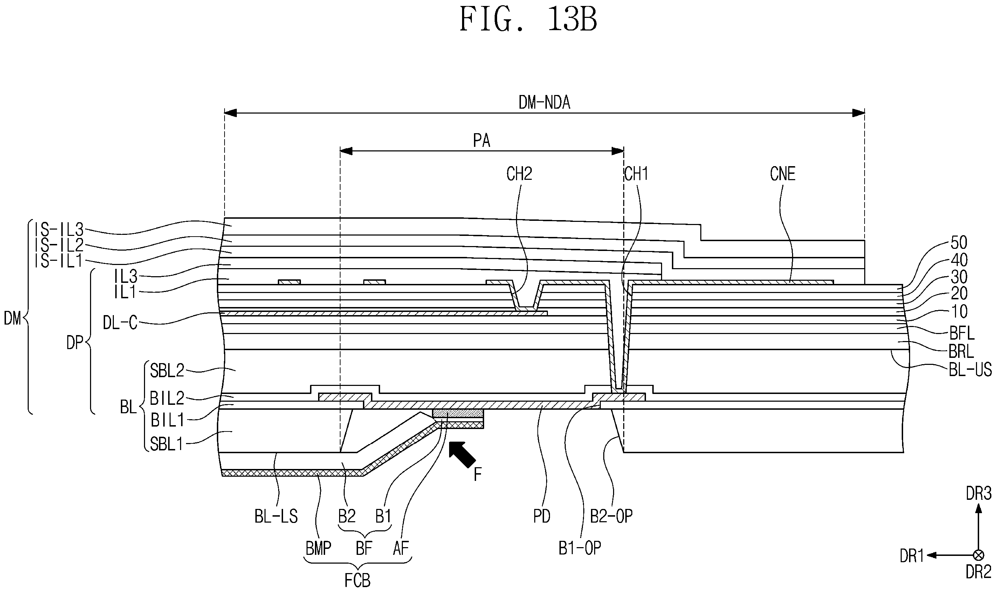

FIG. 13B is a cross-sectional view illustrating operation S400 (see FIG. 11) of bending the base film BF.

Referring to FIG. 13B, the base film BF may be bent toward the pad electrodes PD. For example, the base film BF may be bent so that the first part B1 is parallel to the pad electrodes PD. As illustrated, the base film BF may be bent by an operation of pressing the bump electrodes BMP overlapping the first part B1 toward the pad electrodes PD. A space between the first part B1 and the second part B2 may be bent toward the pad electrodes PD by directly applying a force "F" onto the bump electrodes BMP overlapping the first part B1. As a result, the adhesive layer AF may be in direct contact with the pad electrodes PD, and the first part B1 may be disposed in parallel to the pad electrodes PD.

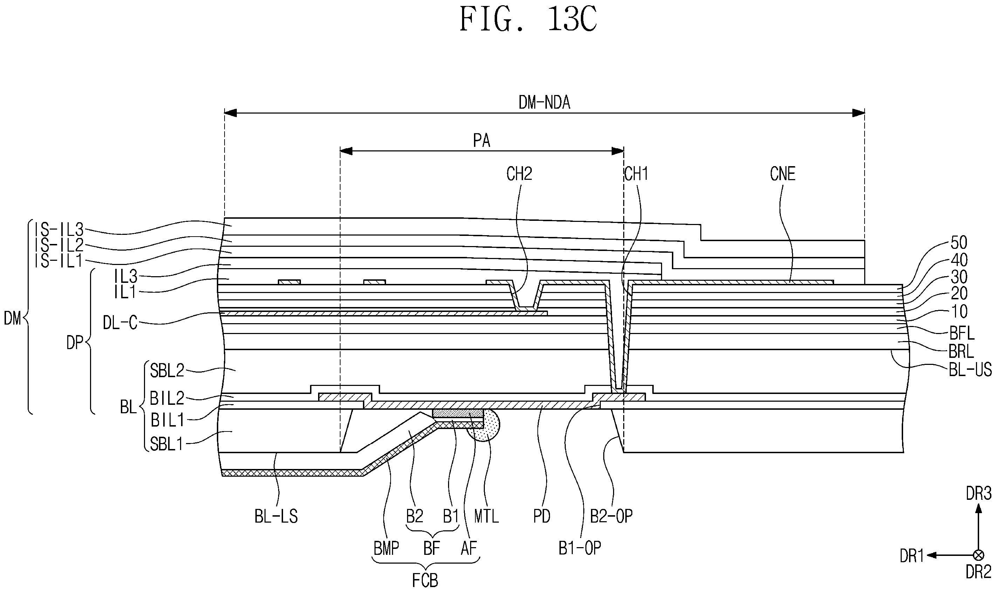

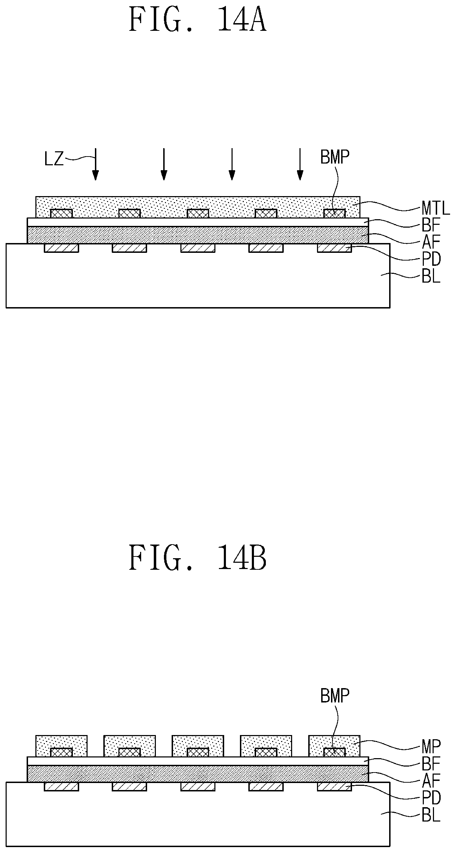

FIGS. 13C to 14B are views illustrating operation S500 (see FIG. 1) of forming the metal pattern MP. FIGS. 14A and 14B are cross-sectional views of a portion of the display device DD to illustrate the operation of forming the metal pattern MP.

Referring to FIGS. 13C and 14A, a metal layer MTL may be disposed on the pad electrodes PD and the bump electrodes BMP. The metal layer MTL may be formed integrally in an area that overlaps the pad electrodes PD and the bump electrodes BMP and an area that is provided between the bump electrodes BMP and does not overlap the bump electrodes BMP. The metal layer MTL may be exposed with a laser beam LZ. The laser beam LZ may be directed to the metal layer MTL disposed in the area that does not overlap the pad electrodes PD and the bump electrodes BMP.

Referring to FIGS. 14A and 14B, as the metal layer MTL disposed in the area that does not overlap the pad electrodes PD and the bump electrodes BMP is exposed by the laser beam LZ, the metal layer MTL disposed in the area that does not overlap the pad electrodes PD and the bump electrodes BMP may be patterned. As a result, the plurality of metal patterns MP arranged in the pad electrodes PD and the bump electrodes BMP may be formed. The metal patterns MP may electrically connect the pad electrodes PD and the bump electrodes BMP.

A flexible circuit board includes a base film including a first part and a second part having different thicknesses and a plurality of bump electrodes arranged on a lower surface of the first part having a small thickness. As the bump electrodes are directly arranged on a lower surface of the first part, in a process of arranging the flexible circuit board so that pad electrodes and the bump electrodes arranged on a rear surface of the display panel face each other, a phenomenon in which the bump electrodes are bend or lifted up may be prevented. As a result, defects due to alignment of the bump electrodes and the pad electrodes may be prevented, and thus a display device having increased reliability may be provided.

Although the description has been made above with reference to embodiments, it will be understood that those skilled in the art or those having ordinary knowledge in the art may variously modify and change the present disclosure without departing from the scope of the invention as defined by the claims.

## Claims

1. A display device, comprising:
a display panel (DP) configured to display an image;
a circuit board (FCB) coupled to the display panel; and
a metal pattern (MP) electrically connecting the display panel and the circuit board to each other,
wherein the display panel (DP) includes:
a base layer (BL) including a pad electrode (PD) that is exposed through an opening; and
a circuit layer (DP-CL) disposed on the base layer and including at least one signal line electrically connected to the pad electrode,
wherein the circuit board (FCB) includes:
a base film (BF, BFa) including a first part (B1) having a first thickness and a second part (B2, B2a) having a second thickness that is greater than the first thickness; and
a bump electrode (BMP) disposed on the first part (B1), wherein the first part is disposed between the pad electrode (PD) and the bump electrode (BMP), and
wherein the metal pattern (MP) is disposed on the pad electrode (PD) and the bump electrode (BMP) and electrically connects the pad electrode (PD) and the bump electrode (BMP) to each other.

2. The display device of claim 1, wherein the pad electrode is a first pad electrode among a plurality of pad electrodes, and
wherein each of the plurality of pad electrodes extend in a first direction and are arranged in a second direction intersecting the first direction.

3. The display device of claim 2, wherein a plurality of bump electrodes and a plurality of metal patterns correspond to the plurality of pad electrodes.

4. The display device of any one of the preceding claims, further comprising:
an adhesive layer (AF) disposed between the first part and the pad electrode.

5. The display device of claim 4, wherein the thickness of the adhesive layer is greater than the first thickness.

6. The display device of claim 4 or 5, wherein the adhesive layer includes a non-conductive film.

7. The display device of any one of the preceding claims, wherein the second part (B2a) includes:
a first sub-portion (MB) that extends parallel to the base layer; and
a second sub-portion (IB) extending from the first sub-portion and including an inclined surface, wherein the second sub-portion is disposed between the first sub-portion and the first part and integrally connects the first sub-portion and the first part to one another.

8. The display device of any one of the preceding claims, wherein the second part (B2a) includes an inclined portion, the thickness of which gradually decreases toward the first part, wherein the inclined portion is adjacent to the first part (B1).

9. The display device of any one of the preceding claims, wherein the first part extends in parallel to the pad electrode and/or, wherein an edge of the first part and an edge of the bump electrode are aligned in parallel to each other.

10. The display device of any one of the preceding claims, wherein the base layer includes:
a first sub-base layer in which the opening is defined; and
a second sub-base layer disposed on the first sub-base layer,
wherein the pad electrode is disposed between the first sub-base layer and the second sub-base layer, wherein the signal line is disposed on an upper surface of the second sub-base layer, and
wherein a contact hole is formed in the second sub-base layer, and the signal line and the pad electrode are connected through the contact hole.

11. The display device of any one of the preceding claims, wherein the first thickness is about 3% to about 20% of the second thickness.

12. A method of manufacturing a display device according to any one of the preceding claims, the method comprising:
forming a display panel including a base layer including a pad electrode exposed through an opening and a circuit layer including at least one signal line electrically connected to the pad electrode;
forming a circuit board including a base film including a first part having a first thickness and a second part having a second thickness that is greater than the first thickness, and a plurality of bump electrodes disposed on the first part;
aligning the display panel and the circuit board such that the first part faces the pad electrodes;
bending the base film such that the first part is parallel to the pad electrodes; and
forming a plurality of metal patterns on the bump electrodes and the pad electrodes to electrically connect the bump electrodes and the pad electrodes to each other through the metal patterns.

13. The method of claim 12, wherein the forming of the circuit board includes:
providing a preliminary base film and preliminary bump electrodes on an upper surface of the preliminary base film;
forming a depression extending in a first direction from a lower surface of the preliminary base film facing the upper surface; and
cutting the preliminary base film and the preliminary bump electrodes in a direction parallel to the first direction while overlapping the depression.

14. The method of claim 13, wherein the forming of the circuit board further includes:
arranging an adhesive layer on the depression before the cutting of the preliminary base film and the preliminary bump electrodes, optionally wherein the forming of the circuit board further includes:
inverting the preliminary base film and the preliminary bump electrodes before the forming of the depression.

15. The method of any one of claims 12 to 14, wherein the bending of the base film incudes:
bending the base film by directly pressing the bump electrode disposed on the first part toward the pad electrode, wherein an angle formed between the first part and the second part is an obtuse angle before the bending of the base film.
